# EUROPEAN PATENT APPLICATION

(11) **EP 4 641 926 A1**
(43) Date of publication of application: **29.10.2025**
(21) Application number: 23906470.2
(22) Date of filing: 27.10.2023
(51) Int. Cl.: H03H 11/20, H01F 21/12, H01F 27/00, H01P 1/18, H03H 7/20

(54) **DIGITAL PHASE SHIFTING CIRCUIT**

(30) Priority: 20.12.2022 JP 2022203325
(71) Applicant: Fujikura Ltd., Tokyo 135-8512 (JP)
(72) Inventor: UEMICHI, Yusuke, Sakura-shi, Chiba 285-8550 (JP)
(74) Representative: Lavoix
(86) International application number: PCT/JP2023/038924
(87) International publication number: WO 2024/135097

(57) **Abstract**

A digital phase shift circuit includes a first circuit connected between a first port and a second port, and a second circuit connected to the first circuit and a common return line and including a variable inductor configured to adjust a phase shift amount for each frequency band.

## Description

### TECHNICAL FIELD

The present invention relates to a digital phase shift circuit.

Priority is claimed on Japanese Patent Application No. 2022-203325 filed December 20, 2022, the content of which is incorporated herein by reference.

### BACKGROUND ART

In recent years, wireless communication using a high-frequency signal such as microwaves, quasi-millimeter waves, millimeter waves, and the like has been attracting attention. In particular, in wireless communication at a frequency higher than a quasi-millimeter wave band, directivity of radio waves is increased, and thus beam forming is required, and a phase shift circuit for achieving the beam forming is indispensable.

For example, Non Patent Document 1 discloses an example of a digital control type phase shift circuit (digital phase shift circuit). The digital phase shift circuit includes a first circuit portion connected between a first port and a second port to which a high-frequency signal is input and output, a second circuit portion connected in parallel to the first circuit portion, and a third circuit portion connected between the second circuit portion and a common return line. The first circuit portion includes a circuit in which a capacitor and a field effect transistor (FET) are connected in parallel. The second circuit portion includes a circuit in which two inductors are connected in series. The third circuit portion includes a circuit in which an inductor and an FET are connected in parallel.

In such a digital phase shift circuit, in a case in which the FET provided in the first circuit portion is set to the closed state, and the FET provided in the third circuit portion is set to the open state, a bypass mode is set. On the other hand, in a case in which the FET provided in the first circuit portion is set to the open state, and the FET provided in the third circuit portion is set to the closed state, a high-pass mode is set.

### Citation List

### Non Patent Document

Non Patent Document 1: "A Compact 5-Bit Phase-Shifter MMIC for K-Band Satellite Communication Systems", IEEE TRANSACTIONS ON MICROWAVE THEORY AND TECHNIQUES, VOL. 48, NO. 12, DECEMBER 2000

### SUMMARY OF INVENTION

### Technical Problem

In the digital phase shift circuit disclosed in Non Patent Document 1, a difference (phase shift amount) between a phase in the bypass mode and a phase in the high-pass mode has frequency dependence. In a case in which such frequency dependence is present, it is considered that a problem may occur in a case in which a high-frequency signal having a wide frequency band is handled. For example, although frequency bands assigned to telecommunications carriers providing telecommunications services, such as mobile phones, are different for each telecommunications carrier, in a case in which the frequency dependence of the phase shift amount described above is present, there is a problem in that the phase shift amount of the digital phase shift circuit may be different for each telecommunications carrier.

The present invention has been made in view of the above-described circumstances, and an object of the present invention is to provide a digital phase shift circuit that can adjust a phase shift amount to be optimal for each frequency band. Solution to Problem

A first aspect of the present invention relates to a digital phase shift circuit (PS1 to PS3) including: a first circuit (100, 100A) connected between a first port (P100) and a second port (P200), and a second circuit (200, 200A, 200B) connected to the first circuit and a common return line (L0) and including a variable inductor (202, 212, 222, 241, ID1 to ID6) configured to adjust a phase shift amount for each frequency band.

In the digital phase shift circuit according to the first aspect of the present invention, the variable inductor that adjusts the phase shift amount for each frequency band is provided, so that the phase shift amount can be adjusted to be optimal for each frequency band.

A second aspect of the present invention relates to the digital phase shift circuit according to the first aspect of the present invention, in which the variable inductor (ID1 to ID3) includes a signal line (1), an inner line (2, 2a, 2b) including a first inner line (2a) provided on a first side of the signal line and a second inner line (2b) provided on a second side of the signal line, an outer line (3, 3a, 3b) provided at a position farther from the signal line than the inner line on at least one of the first side or the second side of the signal line, a first ground conductor (4a) connected to a first end portion of the first inner line, a first end portion of the second inner line, and a first end portion of the outer line, a second ground conductor (4b) connected to a second end portion of the outer line, a first electronic switch (7a) provided between a second end portion of the first inner line and the second ground conductor, and a second electronic switch (7b) provided between a second end portion of the second inner line and the second ground conductor.

A third aspect of the present invention relates to the digital phase shift circuit according to the first aspect of the present invention, in which the variable inductor (ID4 to ID6) includes a signal line (10), a first line (21) including a first parallel line (21p1) extending parallel to the signal line, a second line (22) including a second parallel line (22p2) extending parallel to the signal line, a first intersecting line (22c1) extending away from the signal line in an intersection direction intersecting a longitudinal direction of the signal line from a first end portion of the second parallel line, a third parallel line (22p3) extending parallel to the signal line from a first end portion of the first intersecting line, and a second intersecting line (22c2, 22c2') extending toward the signal line in the intersection direction from a first end portion of the third parallel line, a first ground conductor (31) electrically connected to a first end portion of the first parallel line and the first end portion of the second parallel line, a second ground conductor (32) connected to a first end portion of the second line, a first electronic switch (41) provided between a second end portion of the first parallel line and the second ground conductor, and a second electronic switch (42) provided between a second end portion of the second parallel line and the second ground conductor, and the signal line is located between the first parallel line and the second parallel line.

A fourth aspect of the present invention relates to the digital phase shift circuit according to the third aspect of the present invention, in which the second intersecting line (22c2') extends to intersect the second parallel line, the signal line, and the first parallel line in a plan view, and the second line further includes a fourth parallel line (22p4) extending parallel to the signal line from a first end portion of the second intersecting line, and a third intersecting line (22c3) extending toward the signal line in the intersection direction from a first end portion of the fourth parallel line.

A fifth aspect of the present invention relates to the digital phase shift circuit according to the third aspect of the present invention, in which the first line further includes a fourth intersecting line (21c1) extending away from the signal line in the intersection direction from the first end portion of the first parallel line, a fifth parallel line (21p2) extending parallel to the signal line from a first end portion of the fourth intersecting line, and a fifth intersecting line (21c2) extending toward the signal line in the intersection direction from a first end portion of the fifth parallel line.

A sixth aspect of the present invention relates to the digital phase shift circuit according to any one of the first to fifth aspects of the present invention, in which the first circuit (100) includes a circuit in which a capacitor (101) and a first switch element (102) are connected in parallel, the second circuit (200) includes a pair of inductor circuits (210, 220) connected between a first end of the first circuit and the common return line and between a second end of the first circuit and the common return line, and each of the inductor circuits is a circuit in which a first fixed inductor (211, 221), the variable inductor (212, 222), and a circuit including a second fixed inductor (213, 223) and a second switch element (214, 224) that are connected in parallel are connected in series.

A seventh aspect of the present invention relates to the digital phase shift circuit according to any one of the first to fifth aspects of the present invention, in which the first circuit (100) includes a circuit in which a capacitor (101) and a first switch element (102) are connected in parallel, the second circuit (200) includes a fixed inductor circuit (230) connected in parallel to the first circuit and a variable inductor circuit (240) connected between the fixed inductor circuit and the common return line, the fixed inductor circuit is a circuit including two first fixed inductors (231, 232) connected in series, and the variable inductor circuit is a circuit in which the variable inductor (241) and a circuit including a second fixed inductor (242) and a second switch element (243) that are connected in parallel are connected in series, and is connected to a connection point (Q1) between the two first fixed inductors.

An eighth aspect of the present invention relates to the digital phase shift circuit according to any one of the first to fifth aspects of the present invention, in which the first circuit (100A) is a circuit including two capacitor circuits (110, 120) connected in series, the second circuit is connected between the first circuit and the common return line, the second circuit is a circuit in which a first fixed inductor (201), the variable inductor (202), and a circuit including a second fixed inductor (203) and a second switch element (204) that are connected in parallel are connected in series, and is connected to a connection point (Q2) between the two capacitor circuits, and each of the capacitor circuits is a circuit in which a capacitor (111, 121) and a first switch element (112, 122) are connected in parallel.

### Advantageous Effects of Invention

According to the above-described aspects of the present invention, the phase shift amount can be adjusted to be optimal for each frequency band.

### BRIEF DESCRIPTION OF DRAWINGS

[FIG. 1] A circuit diagram showing a configuration of a digital phase shift circuit according to a first embodiment of the present invention.
[FIG. 2] A perspective view showing a first configuration example of a variable inductor according to the first embodiment of the present invention.
[FIG. 3A] A diagram showing a simulation result of the digital phase shift circuit according to the first embodiment of the present invention.
[FIG. 3B] A diagram showing a simulation result of the digital phase shift circuit according to the first embodiment of the present invention.
[FIG. 4] A circuit diagram showing a configuration of a digital phase shift circuit according to a second embodiment of the present invention.
[FIG. 5] A circuit diagram showing a configuration of a digital phase shift circuit according to a third embodiment of the present invention.
[FIG. 6] A perspective view showing a second configuration example of the variable inductor according to the first to third embodiments of the present invention.
[FIG. 7] A perspective view showing a third configuration example of the variable inductor according to the first to third embodiments of the present invention.
[FIG. 8] A plan view showing a fourth configuration example of the variable inductor according to the first to third embodiments of the present invention.
[FIG. 9] A cross-sectional view taken along a line II-II in FIG. 8.
[FIG. 10] A cross-sectional view taken along a line 111-111 in FIG. 8.
[FIG. 11] A plan view showing a fifth configuration example of the variable inductor according to the first to third embodiments of the present invention.
[FIG. 12] A plan view showing a sixth configuration example of the variable inductor according to the first to third embodiments of the present invention.

### DESCRIPTION OF EMBODIMENTS

Hereinafter, a digital phase shift circuit according to an embodiment of the present invention will be described in detail with reference to the drawings.

### [First Embodiment]

### <Digital Phase Shift Circuit>

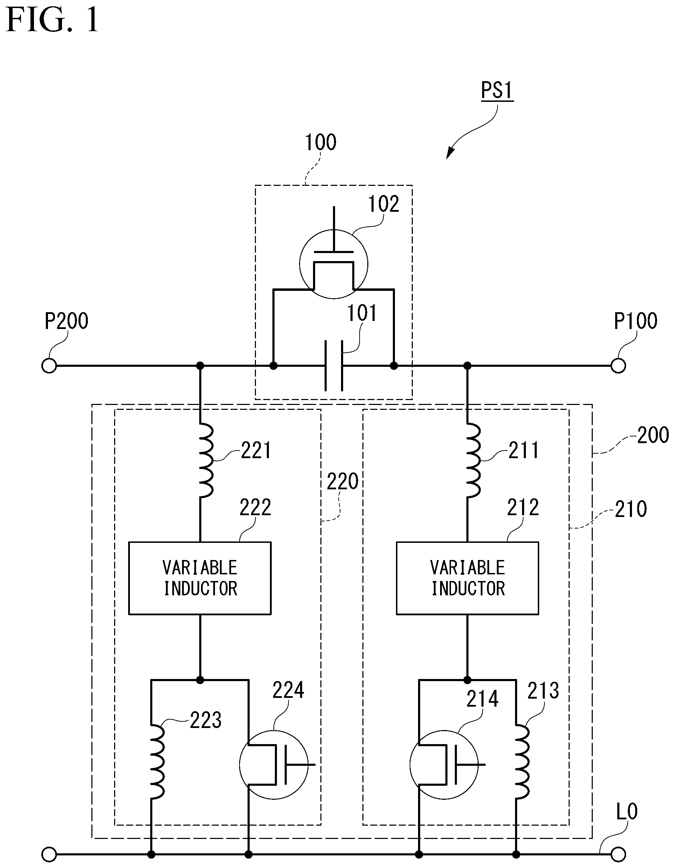

FIG. 1 is a circuit diagram showing a configuration of a digital phase shift circuit according to a first embodiment of the present invention. As shown in FIG. 1, a digital phase shift circuit PS1 of the present embodiment includes a first circuit 100 and a second circuit 200. The first circuit 100 is a circuit connected between a first port P100 and a second port P200. The second circuit 200 is a circuit connected to the first circuit 100 and a common return line L0 (ground line). Such a digital phase shift circuit PS1 receives a high-frequency signal such as microwaves, quasi-millimeter waves, or millimeter waves as an input and outputs a high-frequency signal shifted by a predetermined phase to the outside.

The digital phase shift circuit PS1 has symmetry between the first port P100 and the second port P200. Therefore, in a case in which the high-frequency signal is input from the first port P100, the digital phase shift circuit PS1 outputs the high-frequency signal shifted by the predetermined phase from the second port P200 to the outside. In addition, in a case in which the high-frequency signal is input from the second port P200, the digital phase shift circuit PS1 outputs the high-frequency signal shifted by the predetermined phase from the first port P100 to the outside.

The first circuit 100 includes a circuit in which a capacitor 101 and a switch element 102 (first switch element) are connected in parallel. A first electrode (one electrode) of the capacitor 101 is connected to the first port P100, and a second electrode (the other electrode) is connected to the second port P200. The switch element 102 is, for example, a MOS type field effect transistor (FET), in which a drain terminal is connected to the first electrode of the capacitor 101, a source terminal is connected to the second electrode of the capacitor 101, and a gate terminal is connected to a control unit (not shown). The switch element 102 is controlled by the control unit (not shown) in a case of changing a phase shift amount of the digital phase shift circuit PS1.

The second circuit 200 includes an inductor circuit 210 connected between a first end (one end) of the first circuit 100 and the common return line L0, and an inductor circuit 220 connected between a second end (the other end) of the first circuit 100 and the common return line L0. The digital phase shift circuit PS1 of the present embodiment is a π-type circuit in which the inductor circuits 210 and 220 are connected in parallel to both ends of the first circuit 100. The inductor circuits 210 and 220 correspond to "a pair of inductor circuits".

The inductor circuit 210 is a circuit in which a fixed inductor 211 (first fixed inductor), a variable inductor 212, and a circuit including a fixed inductor 213 (second fixed inductor) and a switch element 214 (second switch element) that are connected in parallel are connected in series. The fixed inductor 211 has a first end (one end) connected to the first end (first port P100) of the first circuit 100, and has a second end (the other end) connected to a first end (one end) of the variable inductor 212.

The variable inductor 212 has the first end connected to the second end of the fixed inductor 211, and has a second end (the other end) connected to a first end (one end) of the fixed inductor 213. The fixed inductor 213 has the first end connected to the second end of the variable inductor 212, and has a second end (the other end) connected to the common return line L0. The switch element 214 is, for example, a MOS type FET, in which a drain terminal is connected to the first end of the fixed inductor 213 and the second end of the variable inductor 212, a source terminal is connected to the second end (common return line L0) of the fixed inductor 213, and a gate terminal is connected to the control unit (not shown). The switch element 214 is controlled by the control unit (not shown) in a case of changing the phase shift amount of the digital phase shift circuit PS1. The fixed inductor 211 and the variable inductor 212 may be arranged in the opposite order (may be switched).

The inductor circuit 220 is a circuit in which a fixed inductor 221 (first fixed inductor), a variable inductor 222, and a circuit including a fixed inductor 223 (second fixed inductor) and a switch element 224 (second switch element) that are connected in parallel are connected in series. The fixed inductor 221 has a first end (one end) connected to the second end (second port P200) of the first circuit 100, and has a second end (the other end) connected to one end of the variable inductor 222.

The variable inductor 222 has a first end (one end) connected to the second end of the fixed inductor 221, and has a second end (the other end) connected to a first end (one end) of the fixed inductor 223. The fixed inductor 223 has the first end connected to the second end of the variable inductor 222, and has a second end (the other end) connected to the common return line L0. The switch element 224 is, for example, a MOS type FET, in which a drain terminal is connected to the first end of the fixed inductor 223 and the second end of the variable inductor 222, a source terminal is connected to the second end (common return line L0) of the fixed inductor 223, and a gate terminal is connected to the control unit (not shown). The switch element 224 is controlled by the control unit (not shown) in a case of changing the phase shift amount of the digital phase shift circuit PS1. The fixed inductor 221 and the variable inductor 222 may be arranged in the opposite order (may be switched).

The variable inductor 212 provided in the inductor circuit 210 and the variable inductor 222 provided in the inductor circuit 220 are used for adjusting the phase shift amount of the digital phase shift circuit PS1. The control unit (not shown) controls the variable inductors 212 and 222 to change the value of the inductance of the variable inductor, so that the phase shift amount of the digital phase shift circuit PS1 is adjusted. The details of the variable inductors 212 and 222 will be described below.

**In** the above-described configuration, the control unit (not shown) controls the switch element 102 provided in the first circuit 100 and the switch elements 214 and 224 provided in the second circuit 200, so that the phase shift amount of the digital phase shift circuit PS1 is changed. For example, in a case in which the control unit (not shown) sets the switch element 102 to the closed state and sets the switch elements 214 and 224 to the open state, a bypass mode is set, and the phase of the high-frequency signal output from the digital phase shift circuit PS1 becomes φₓ. On the other hand, in a case in which the control unit (not shown) sets the switch element 102 to the open state and sets the switch elements 214 and 224 to the closed state, a high-pass mode is set, and the phase of the high-frequency signal output from the digital phase shift circuit PS1 becomes φ_{y}. In this way, the phase shift amount (difference between the phase φₓ and the phase φ_{y}) of the digital phase shift circuit PS1 is controlled by the control unit (not shown).

Here, in the digital phase shift circuit PS1, it is ideal that a specific phase shift amount be obtained in all of the frequency bands of the high-frequency signal, but in general, a desired phase shift amount is obtained only at a specific frequency. For example, in a case in which the frequency band of the high-frequency signal is n260 (37 to 40 GHz), it is ideal that a specific phase shift amount (for example, 90°) be obtained in the entire frequency band, but a desired phase shift amount is obtained only at a specific frequency (for example, 40 GHz). In such a case, the control unit (not shown) controls the variable inductors 212 and 222 provided in the second circuit 200 to adjust the phase shift amount of the digital phase shift circuit PS1, so that a desired phase shift amount or a phase shift amount close thereto is obtained even at a frequency other than the specific frequency.

### <Variable Inductor>

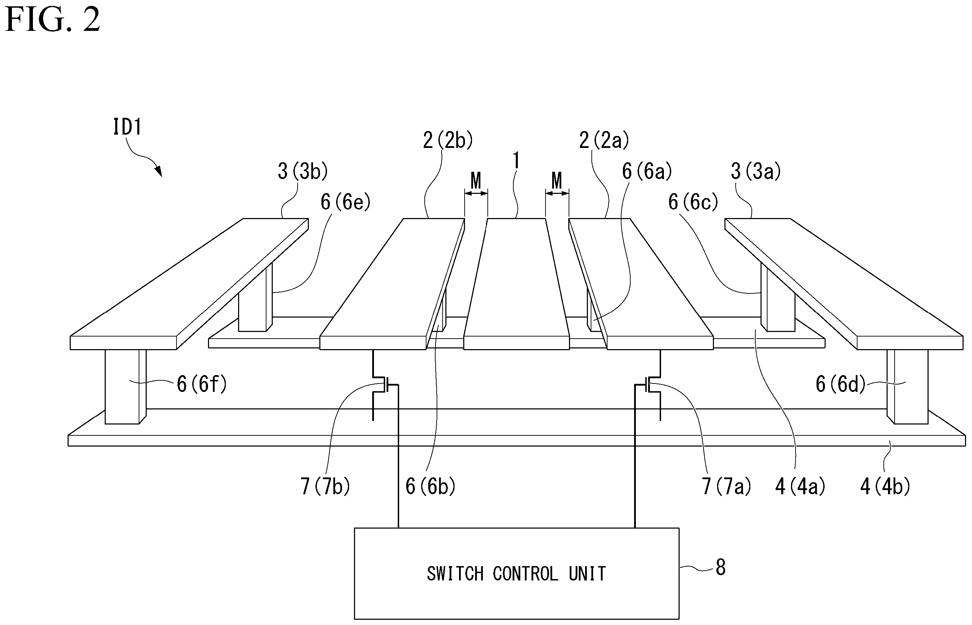

FIG. 2 is a perspective view showing a first configuration example of the variable inductor according to the first embodiment of the present invention. A variable inductor ID1 shown in FIG. 2 includes a signal line 1, two inner lines 2 (inner lines 2a and 2b), two outer lines 3 (outer lines 3a and 3b), two ground conductors 4 (ground conductors 4a and 4b), a plurality of connection conductors 6, two electronic switches 7 (electronic switches 7a and 7b), and a switch control unit 8.

The signal line 1 is a linear strip-shaped conductor extending in a predetermined direction. That is, the signal line 1 is an elongated plate-shaped conductor having a constant width, a constant thickness, and a predetermined length. In the example shown in FIG. 2, a signal current flows from the front side to the rear side in the signal line 1. The signal current may flow from the rear side to the front side of the signal line 1. For example, the signal line 1 has the front side connected to the second end of the fixed inductor 211 (fixed inductor 221) shown in FIG. 1, and has the rear side connected to the first end of the fixed inductor 213 (fixed inductor 223) shown in FIG. 1.

The inner line 2 is a linear strip-shaped conductor. That is, the inner line 2 is an elongated plate-shaped conductor having a constant width, a constant thickness, and a predetermined length. The inner line 2 extends in the same direction as the extending direction of the signal line 1. The inner line 2 is provided parallel to the signal line 1. The inner line 2a (first inner line) is disposed from the first side (one side) of the signal line 1 by a predetermined distance M, and the inner line 2b (second inner line) is disposed from the second side (the other side) of the signal line 1 by the predetermined distance M. The predetermined distance M is set to be less than 10 µm. The predetermined distance M is more preferably, for example, 2 µm or less, and it is desirable to bring the inner line 2 as close as possible to the signal line 1. For example, it is desirable to bring the inner line 2 close to the manufacturing limit or close to the vicinity of the manufacturing limit of the signal line 1.

The outer line 3 is a linear strip-shaped conductor provided at a position farther from the signal line 1 than the inner line 2. That is, the outer line 3 is an elongated plate-shaped conductor having a constant width, a constant thickness, and a predetermined length. The outer line 3 extends in the same direction as the extending direction of the signal line 1, similarly to the inner line 2. The outer line 3 is provided parallel to the signal line 1. The outer line 3a (first outer line) is provided at a position farther from the signal line 1 than the inner line 2a on the first side of the signal line 1, and the outer line 3b (second outer line) is provided at a position farther from the signal line 1 than the inner line 2b on the second side of the signal line 1.

The ground conductor 4 is a linear strip-shaped conductor that is disposed below the inner line 2 and the outer line 3 at a predetermined distance and that is provided to be orthogonal to the inner line 2 and the outer line 3. That is, the ground conductor 4 is an elongated plate-shaped conductor having a constant width, a constant thickness, and a predetermined length. The ground conductor 4a (first ground conductor) is provided on the first end (one end) side of each of the inner line 2a, the inner line 2b, the outer line 3a, and the outer line 3b, and is electrically connected to each first end of the inner line 2a, the inner line 2b, the outer line 3a, and the outer line 3b. The ground conductor 4b (second ground conductor) is provided on the second end (the other end) side of each of the inner line 2a, the inner line 2b, the outer line 3a, and the outer line 3b, and is electrically connected to each second end of the outer line 3a and the outer line 3b. The ground conductor 4b is disposed parallel to the ground conductor 4a.

The plurality of connection conductors 6 include at least connection conductors 6a to 6f. The connection conductor 6a electrically and mechanically connects the first end of the inner line 2a and the ground conductor 4a. The connection conductor 6b electrically and mechanically connects the first end of the inner line 2b and the ground conductor 4a. The connection conductor 6c electrically and mechanically connects the first end of the outer line 3a and the ground conductor 4a. The connection conductor 6d electrically and mechanically connects the second end of the outer line 3a and the ground conductor 4b. The connection conductor 6e electrically and mechanically connects the first end of the outer line 3b and the ground conductor 4a. The connection conductor 6f electrically and mechanically connects the second end of the outer line 3b and the ground conductor 4b.

The electronic switch 7 is, for example, a MOS type FET, and is controlled to be in the closed state or the open state based on a gate signal input to the gate terminal from the switch control unit 8. The closed state is a state in which the drain terminal and the source terminal are in conduction. The open state is a state in which the drain terminal and the source terminal are not in conduction, and the electrical connection is cut off.

The electronic switch 7a (first electronic switch) is connected between the second end of the inner line 2a and the ground conductor 4b. Specifically, in the electronic switch 7a, the drain terminal is electrically connected to the second end of the inner line 2a, the source terminal is electrically connected to the ground conductor 4b, and the gate terminal is electrically connected to the switch control unit 8. The electronic switch 7a switches between a conduction state in which the second end of the inner line 2a and the ground conductor 4b are electrically connected to each other and a cut-off state in which the electrical connection is cut off, under the control of the switch control unit 8. The size of the electronic switch 7a is, for example, equal to or greater than the width of the ground conductor 4b.

The electronic switch 7b (second electronic switch) is connected between the second end of the inner line 2b and the ground conductor 4b. Specifically, in the electronic switch 7b, the drain terminal is electrically connected to the second end of the inner line 2b, the source terminal is electrically connected to the ground conductor 4b, and the gate terminal is electrically connected to the switch control unit 8. The electronic switch 7b switches between a conduction state in which the second end of the inner line 2b and the ground conductor 4b are electrically connected to each other and a cut-off state in which the electrical connection is cut off, under the control of the switch control unit 8. The size of the electronic switch 7b is, for example, equal to or greater than the width of the ground conductor 4b.

The switch control unit 8 is a control circuit that controls the electronic switch 7 (electronic switch 7a and electronic switch 7b). For example, the switch control unit 8 includes two output ports. The switch control unit 8 outputs an individual gate signal from each output port and supplies the individual gate signal to each gate terminal of the plurality of electronic switches 7, to individually control each of the plurality of electronic switches 7 to the open state or the closed state.

In the above-described configuration, in a case in which the electronic switch 7a and the electronic switch 7b are controlled to be in the closed state by the switch control unit 8, the variable inductor ID1 enters a low-inductance mode. On the other hand, in a case in which the electronic switch 7a and the electronic switch 7b are controlled to be in the open state by the switch control unit 8, the variable inductor ID1 enters a high-inductance mode.

In the low-inductance mode, the inductance of the variable inductor ID1 is reduced due to a return current flowing through the inner line 2 (inner lines 2a and 2b). On the other hand, in the high-inductance mode, the return current flows through the outer line 3 (outer lines 3a and 3b), and thus the inductance of the variable inductor ID1 increases compared with the low-inductance mode. As described above, the variable inductor ID1 shown in FIG. 2 can change the inductance by switching between the closed state and the open state of the electronic switches 7a and 7b.

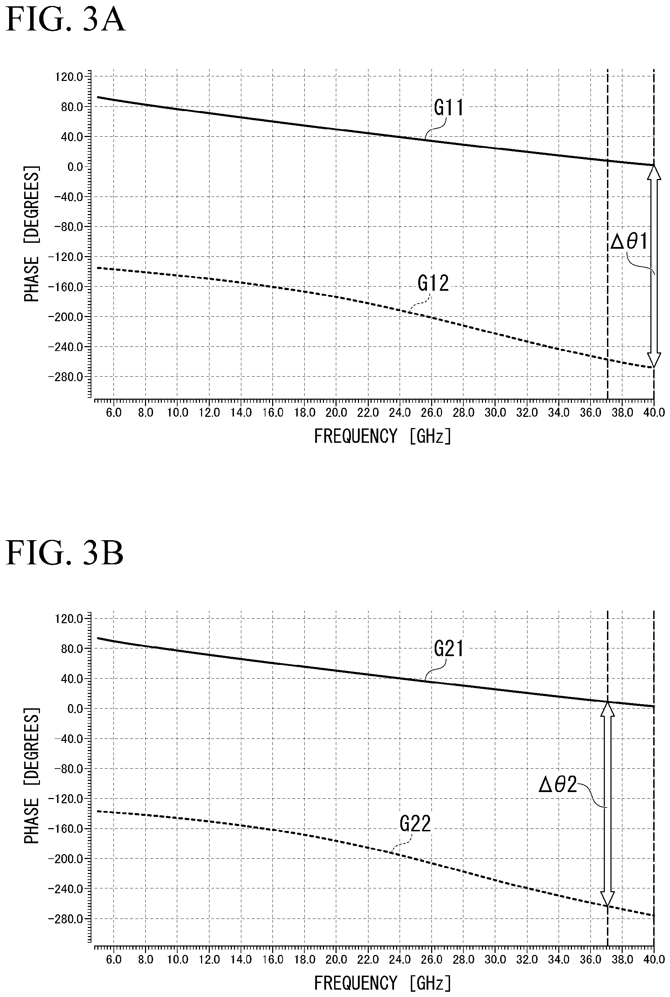

FIGS. 3A and 3B are diagrams showing simulation results of the digital phase shift circuit according to the first embodiment of the present invention. The digital phase shift circuit PS1 to be simulated is designed such that the phase shift amount is 90° in the frequency band n260 (37 to 40 GHz). The simulation results shown in FIGS. 3A and 3B show the frequency characteristics of the passing phase characteristics of the digital phase shift circuit PS1. In the graphs shown in FIGS. 3A and 3B, a horizontal axis represents a frequency [GHz], and a vertical axis represents a phase [degrees].

In FIG. 3A, a curve denoted by a reference sign G11 is a curve showing the frequency characteristics of the phase of the digital phase shift circuit PS1 in a case in which the digital phase shift circuit PS1 is set to the bypass mode, and the variable inductor ID1 is set to the high-inductance mode. A curve denoted by a reference sign G12 is a curve showing frequency characteristics of the phase of the digital phase shift circuit PS1 in a case in which the digital phase shift circuit PS1 is set to the high-pass mode, and the variable inductor ID1 is set to the low-inductance mode.

Referring to FIG. 3A, it can be seen that the phase shift amount Δθ1 of the digital phase shift circuit PS1 at the highest frequency (40 GHz) in the frequency band n260 (37 to 40 GHz) is approximately 90°, and the design value of the phase shift amount can be achieved. In addition, in a case in which the same simulation is performed on a digital phase shift circuit (hereinafter, referred to as a "related-art circuit") having a configuration in which the variable inductors 212 and 222 are omitted from the digital phase shift circuit PS1 shown in FIG. 1, the phase shift amount corresponding to the phase shift amount Δθ1 is approximately 83°. Therefore, it can be seen that the phase shift amount is improved by approximately 7° by providing the variable inductors 212 and 222.

In FIG. 3B, a curve denoted by a reference sign G21 is a curve showing the frequency characteristics of the phase of the digital phase shift circuit PS1 in a case in which the digital phase shift circuit PS1 is set to the bypass mode, and the variable inductor ID1 is set to the low-inductance mode. A curve denoted by a reference sign G22 is a curve showing frequency characteristics of the phase of the digital phase shift circuit PS1 in a case in which the digital phase shift circuit PS1 is set to the high-pass mode, and the variable inductor ID1 is set to the high-inductance mode.

Referring to FIG. 3B, it can be seen that the phase shift amount Δθ2 of the digital phase shift circuit PS1 at the lowest frequency (37 GHz) in the frequency band n260 (37 to 40 GHz) is 87.7°, and the phase shift amount close to the design value (90°) can be achieved. In addition, in a case in which the same simulation is performed on the related-art circuit, the phase shift amount corresponding to the phase shift amount Δθ2 is approximately 88°. Therefore, it can be seen that the phase shift amount is slightly deteriorated (deteriorated by 0.3°) by providing the variable inductors 212 and 222, but the phase shift amount is improved in the entire frequency band n260 (37 to 40 GHz).

As described above, the digital phase shift circuit PS1 of the present embodiment includes the first circuit 100 connected between the first port P100 and the second port P200, and the second circuit 200 connected to the first circuit 100 and the common return line L0. Since the variable inductors 212 and 222 that adjust the phase shift amount for each frequency band are provided in the second circuit 200, the phase shift amount of the digital phase shift circuit PS1 can be adjusted to be optimal for each frequency band.

### [Second Embodiment]

### <Digital Phase Shift Circuit>

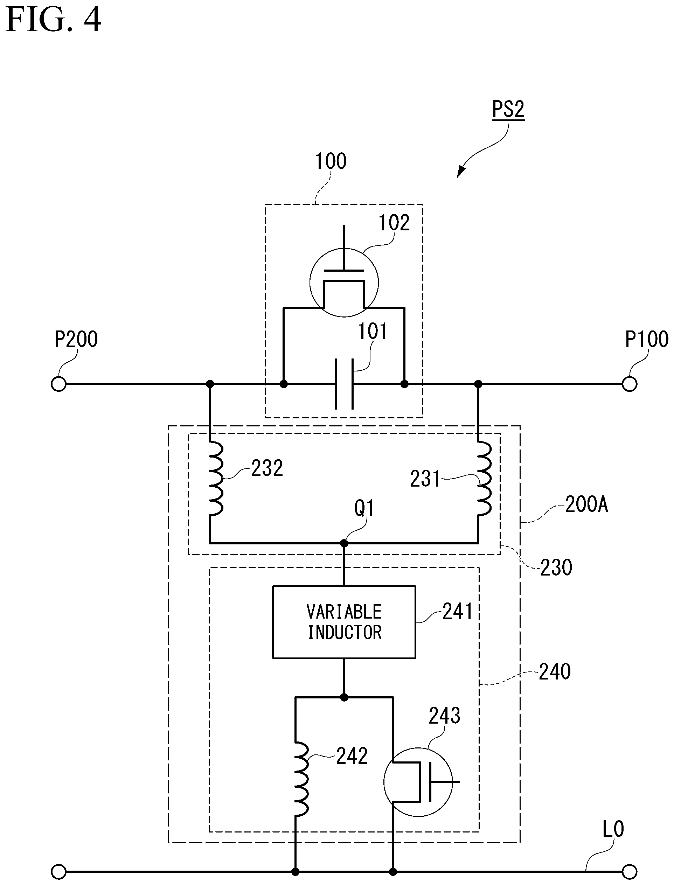

FIG. 4 is a circuit diagram showing a configuration of a digital phase shift circuit according to a second embodiment of the present invention. In FIG. 4, the configurations corresponding to the configurations shown in FIG. 1 are denoted by the same reference signs. The description of the same configurations denoted by the same reference signs will be omitted, and only the different points will be described.

As shown in FIG. 4, a digital phase shift circuit PS2 of the present embodiment has a configuration in which the second circuit 200 of the digital phase shift circuit PS1 shown in FIG. 1 is replaced with a second circuit 200A. Such a digital phase shift circuit PS2 is a simplified version of the configuration of the digital phase shift circuit PS1 shown in FIG. 1.

The second circuit 200A includes a fixed inductor circuit 230 connected in parallel to the first circuit 100 and a variable inductor circuit 240 connected between the fixed inductor circuit 230 and the common return line L0. The fixed inductor circuit 230 is a circuit including two fixed inductors 231 and 232 (second fixed inductors) connected in series. The variable inductor circuit 240 is a circuit in which a variable inductor 241 and a circuit including a fixed inductor 242 (second fixed inductor) and a switch element 243 (second switch element) that are connected in parallel are connected in series. The variable inductor circuit 240 has a first end (one end) connected to a connection point Q1 between of the fixed inductors 231 and 232 in the fixed inductor circuit 230, and has a second end (the other end) connected to the common return line L0.

The variable inductor 241 is the same circuit as the variable inductors 212 and 222 shown in FIG. 1, and includes, for example, the variable inductor ID1 shown in FIG. 2. The fixed inductor 242 is the same as the fixed inductors 213 and 223 shown in FIG. 1, and the switch element 243 is the same as the switch elements 214 and 224 shown in FIG. 1.

Therefore, the digital phase shift circuit PS2 of the present embodiment can be said to be a circuit in which the variable inductors 212 and 222, the fixed inductors 213 and 223, and the switch elements 214 and 224 provided in the digital phase shift circuit PS1 shown in FIG. 1 are used in common. Specifically, the variable inductors 212 and 222 shown in FIG. 1 are used in common to form the variable inductor 241, the fixed inductors 213 and 223 are used in common to form the fixed inductor 242, and the switch elements 214 and 224 are used in common to form the switch element 243.

In the above-described configuration, the control unit (not shown) controls the switch element 102 provided in the first circuit 100 and the switch element 243 provided in the second circuit 200A, so that the phase shift amount of the digital phase shift circuit PS2 is changed. For example, in a case in which the control unit (not shown) sets the switch element 102 to the closed state and sets the switch element 243 to the open state, the bypass mode is set. On the other hand, in a case in which the control unit (not shown) sets the switch element 102 to the open state and the switch element 243 to the closed state, the high-pass mode is set. In this way, the phase shift amount of the digital phase shift circuit PS2 is controlled by the control unit (not shown). Here, the control unit (not shown) controls the variable inductor 241 provided in the second circuit 200A, to adjust the phase shift amount of the digital phase shift circuit PS2, so that a specific phase shift amount can be obtained even at some frequencies at which the specific phase shift amount cannot be obtained.

As described above, the digital phase shift circuit PS2 of the present embodiment includes the first circuit 100 connected between the first port P100 and the second port P200, and the second circuit 200A connected to the first circuit 100 and the common return line L0. Since the variable inductor 241 that adjusts the phase shift amount for each frequency band is provided in the second circuit 200A, the phase shift amount of the digital phase shift circuit PS2 can be adjusted to be optimal for each frequency band.

### [Third Embodiment]

### <Digital Phase Shift Circuit>

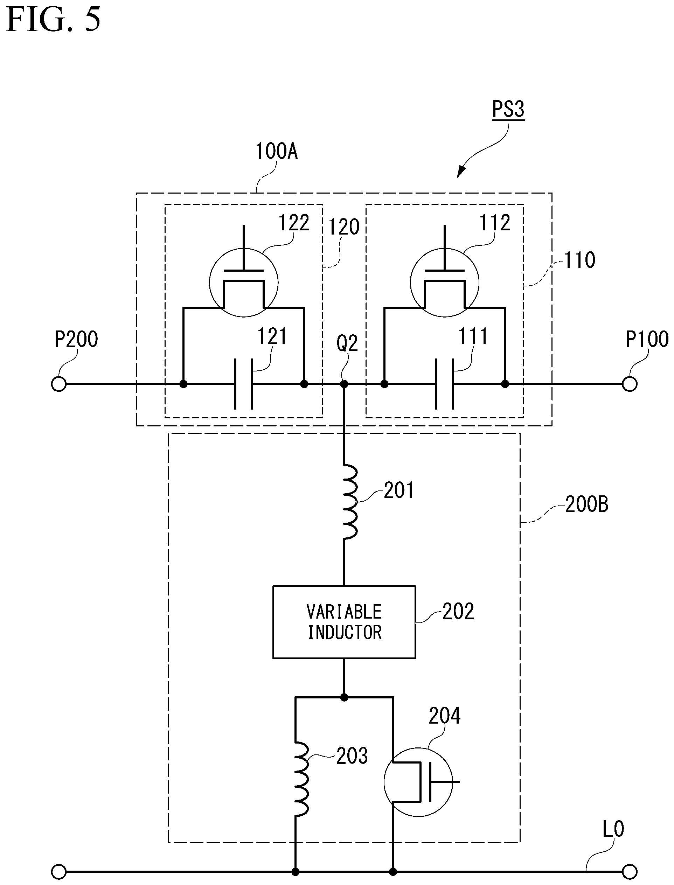

FIG. 5 is a circuit diagram showing a configuration of a digital phase shift circuit according to a third embodiment of the present invention. In FIG. 5, the configurations corresponding to the configurations shown in FIG. 1 are denoted by the same reference signs. The description of the same configurations denoted by the same reference signs will be omitted, and only the different points will be described.

As shown in FIG. 5, a digital phase shift circuit PS3 of the present embodiment has a configuration in which the first circuit 100 of the digital phase shift circuit PS1 shown in FIG. 1 is replaced with a first circuit 100A, and the second circuit 200 is replaced with a second circuit 200B.

The first circuit 100A is a circuit including two capacitor circuits 110 and 120 connected in series. The capacitor circuit 110 includes a circuit in which a capacitor 111 and a switch element 112 (first switch element) are connected in parallel. The capacitor circuit 120 includes a circuit in which a capacitor 121 and a switch element 122 (first switch element) are connected in parallel.

The capacitor 111 has a first electrode (one electrode) connected to the first port P100, and has a second electrode (the other electrode) connected to one electrode of the capacitor 121. The switch element 112 is, for example, a MOS type FET, in which a drain terminal is connected to the first electrode of the capacitor 111, a source terminal is connected to the second electrode of the capacitor 111, and a gate terminal is connected to the control unit (not shown). The switch element 112 is controlled by the control unit (not shown) in a case of changing the phase shift amount of the digital phase shift circuit PS3.

The capacitor 121 has a first electrode (one electrode) connected to the second electrode of the capacitor 111, and has a second electrode (the other electrode) connected to the second port P200. The switch element 122 is, for example, a MOS type FET, in which a drain terminal is connected to the first electrode of the capacitor 121, a source terminal is connected to the second electrode of the capacitor 121, and a gate terminal is connected to the control unit (not shown). The switch element 122 is controlled by the control unit (not shown) in a case of changing the phase shift amount of the digital phase shift circuit PS3.

The second circuit 200B is a circuit in which a fixed inductor 201 (first fixed inductor), a variable inductor 202, and a circuit including a fixed inductor 203 (second fixed inductor) and a switch element 204 (second switch element) that are connected in parallel are connected in series. The second circuit 200B is the same circuit as the inductor circuits 210 and 220 provided in the second circuit 200 of the digital phase shift circuit PS1 shown in FIG. 1. The second circuit 200B is connected between a connection point Q2 between the capacitor circuits 110 and 120 provided in the first circuit 100A and the common return line L0. The digital phase shift circuit PS3 of the present embodiment is a T-type circuit in which the second circuit 200B is connected to the connection point Q2 between the capacitor circuits 110 and 120 connected in series.

In the above-described configuration, the control unit (not shown) controls the switch elements 112 and 122 provided in the first circuit 100A and the switch element 204 provided in the second circuit 200B, so that the phase shift amount of the digital phase shift circuit PS3 is changed. For example, in a case in which the control unit (not shown) sets the switch elements 112 and 122 to the closed state and sets the switch element 204 to the open state, the bypass mode is set. On the other hand, in a case in which the control unit (not shown) sets the switch elements 112 and 122 to the open state and sets the switch element 204 to the closed state, the high-pass mode is set. In this way, the phase shift amount of the digital phase shift circuit PS3 is controlled by the control unit (not shown). Here, the control unit (not shown) controls the variable inductor 202 provided in the second circuit 200B to adjust the phase shift amount of the digital phase shift circuit PS3, so that a specific phase shift amount can be obtained even at some frequencies at which the specific phase shift amount cannot be obtained.

As described above, the digital phase shift circuit PS3 of the present embodiment includes the first circuit 100A connected between the first port P100 and the second port P200, and the second circuit 200B connected to the first circuit 100A and the common return line L0. Since the variable inductor 202 that adjusts the phase shift amount for each frequency band is provided in the second circuit 200B, the phase shift amount of the digital phase shift circuit PS3 can be adjusted to be optimal for each frequency band.

The digital phase shift circuit according to the embodiment of the present invention has been described above, but the present invention is not limited to the above-described embodiments and can be freely changed within the scope of the present invention. For example, the variable inductor provided in the digital phase shift circuits PS1 to PS3 according to the first to third embodiments described above is not limited to the variable inductor including the variable inductor ID1 shown in FIG. 2. For example, the variable inductor including variable inductors ID2 to ID6 described below can also be used.

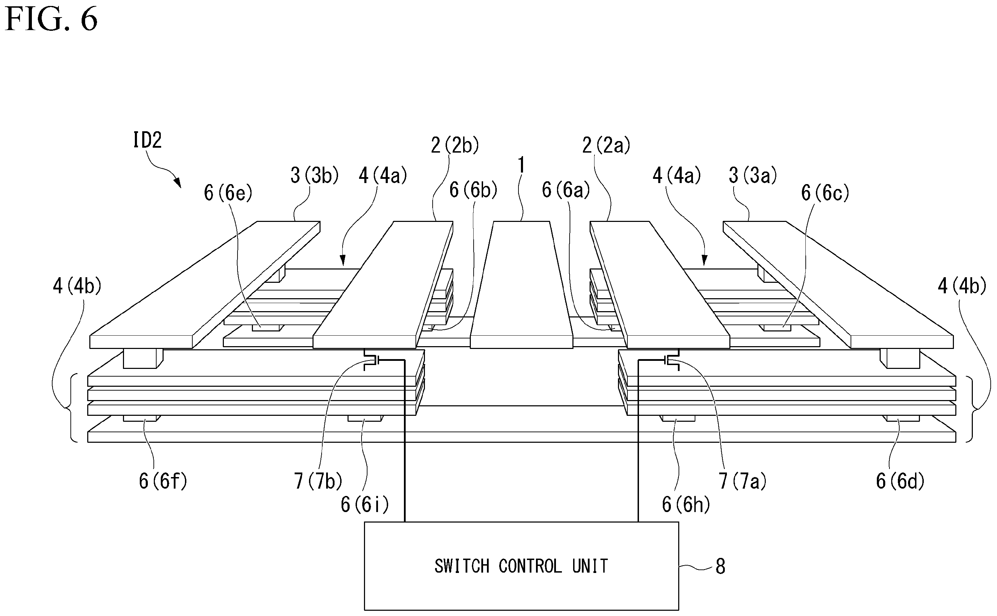

FIG. 6 is a perspective view showing a second configuration example of the variable inductor according to the first to third embodiments of the present invention. The variable inductor ID2 shown in FIG. 6 is different from the variable inductor ID1 shown in FIG. 2 in that the ground conductor 4a and the ground conductor 4b are formed in a multilayer structure between the outer line 3 and the inner line 2. The ground conductor 4a and the ground conductor 4b may be formed in a multilayer structure also between the inner line 2a and the inner line 2b.

The ground conductor 4a formed in a multilayer structure is connected to each other through a plurality of via holes (connection conductors 6a, 6b, 6c, and 6e). The ground conductor 4b formed in a multilayer structure is connected to each other through a plurality of via holes (connection conductors 6d, 6f, 6h, and 6i).

With this configuration, the resistance value of the ground conductor 4 between the outer line 3 and the inner line 2 can be reduced, and the loss of the high-frequency signal in the high-inductance mode can be reduced. Therefore, it is possible to reduce the unbalance in the signal amplitude between the high-inductance mode and the low-inductance mode. The variable inductor ID2 shown in FIG. 6 can also change the inductance of the variable inductor ID2 by switching between the closed state and the open state of the electronic switches 7a and 7b.

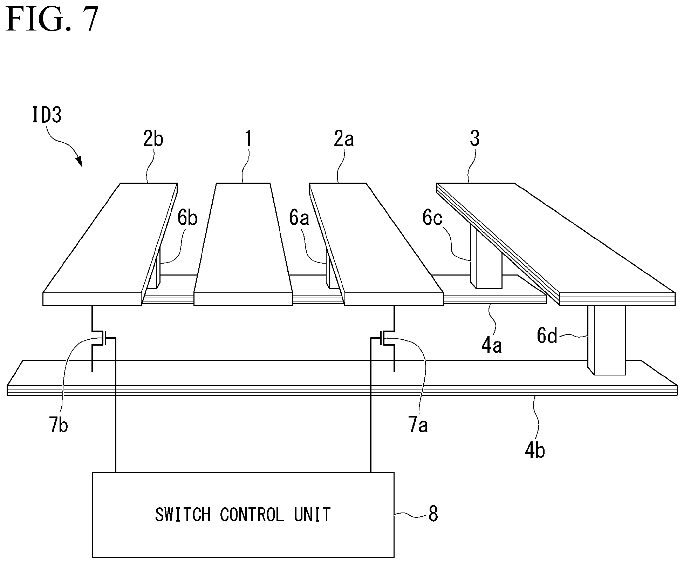

FIG. 7 is a perspective view showing a third configuration example of the variable inductor according to the first to third embodiments of the present invention. The variable inductor ID3 shown in FIG. 7 is different from the variable inductor ID1 shown in FIG. 2 in that the outer line 3b is omitted, the outer line 3 is formed to be wider than the width of the inner line 2, and the outer line 3, the ground conductor 4a, and the ground conductor 4b are formed in a multilayer structure. Only one of multilayering of the ground conductors 4a and 4b or the widening and multilayering of the outer line 3 may be performed as necessary. That is, only the multilayering of the ground conductors 4a and 4b may be performed, or only the widening and multilayering of the outer line 3 may be performed.

With such a configuration, it is possible to achieve the size reduction in the variable inductor ID3. Since the impedance of the ground conductors 4a and 4b can be reduced, the overall loss of the variable inductor ID3 can be reduced. In addition, since the impedance of the outer line 3 can be reduced, a difference between the loss of the variable inductor ID3 in the low-inductance mode and the loss of the variable inductor ID3 in the high-inductance mode can be reduced. The variable inductor ID3 shown in FIG. 7 can also change the inductance of the variable inductor ID3 by switching between the closed state and the open state of the electronic switches 7a and 7b.

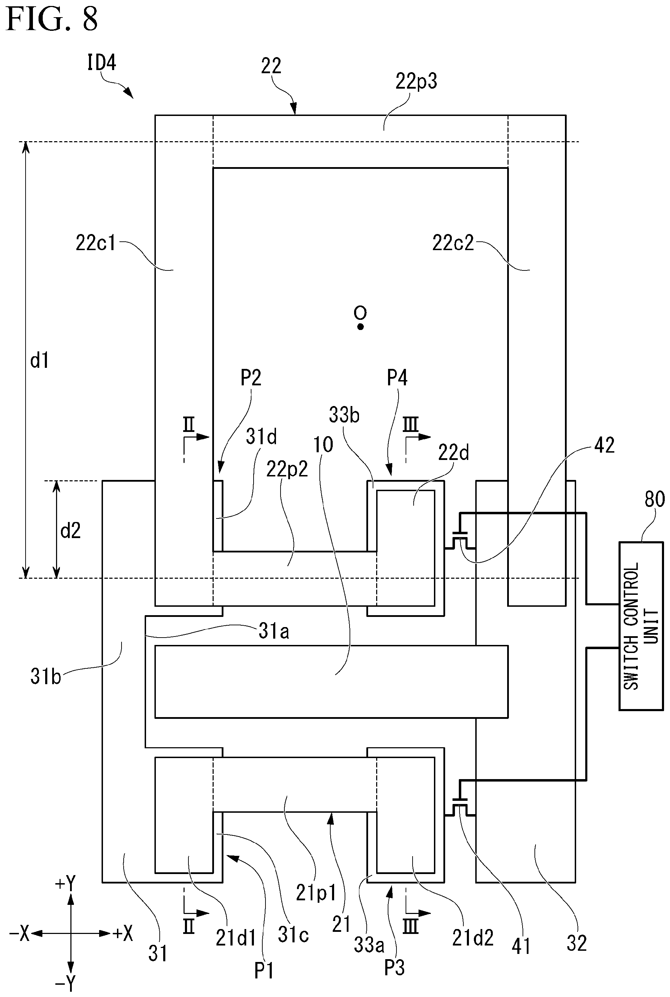

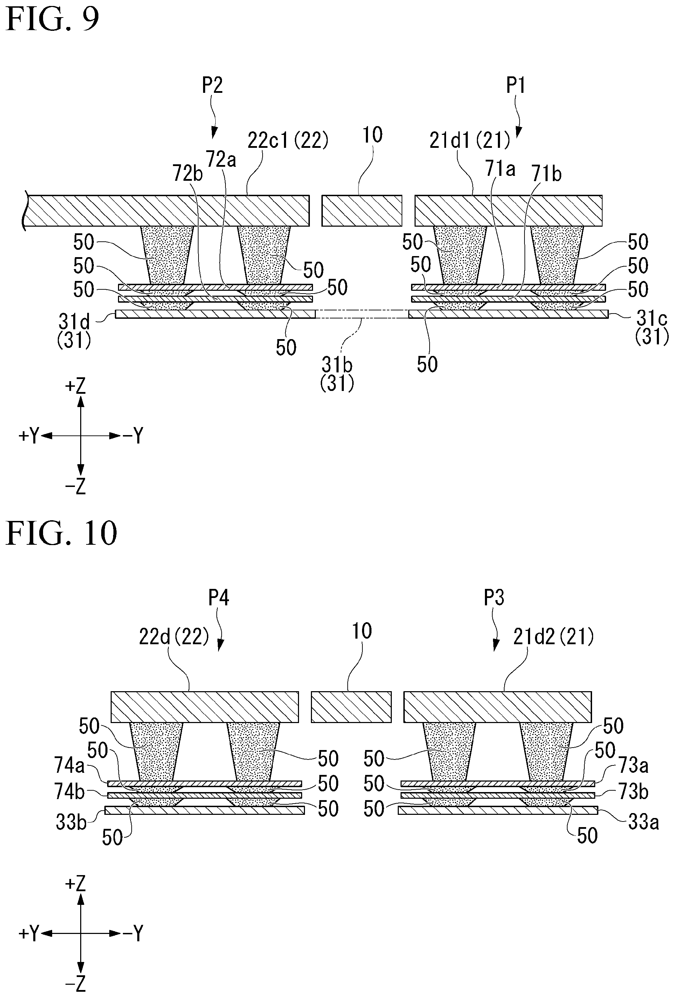

FIG. 8 is a plan view showing a fourth configuration example of the variable inductor according to the first to third embodiments of the present invention. FIG. 9 is a cross-sectional view taken along a line II-II in FIG. 8. FIG. 10 is a cross-sectional view taken along a line 111-111 in FIG. 8.

As shown in FIG. 8, the variable inductor ID4 includes a signal line 10, a first line 21, a second line 22, a first ground conductor 31, and a second ground conductor 32. The first line 21 in the present embodiment includes a first parallel line 21p1 and a pair of upper pads 21d1 and 21d2. The second line 22 in the present embodiment includes a second parallel line 22p2, a first intersecting line 22c1, a third parallel line 22p3, a second intersecting line 22c2, and an upper pad 22d. In addition, the variable inductor ID4 in the present embodiment includes the first electronic switch 41 and the second electronic switch 42, a plurality of connection conductors 50, and a plurality of connection pads P1 to P4 (see also FIGS. 9 and 10).

As shown in FIG. 8, the signal line 10 is a linear strip-shaped conductor extending in one direction. That is, the signal line 10 is an elongated plate-shaped conductor having a constant width, a constant thickness, and a predetermined length. In the signal line 10, a signal current flows from a left side of a paper surface to a right side of the paper surface in FIG. 8, that is, from an end portion (input end) on the left side of the paper surface to an end portion (output end) on the right side of the paper surface. This signal current is a high-frequency signal having a wavelength range of microwaves, quasi-millimeter waves, or millimeter waves as described above. For example, the signal line 10 has the input end connected to the second end of the fixed inductor 211 (fixed inductor 221) shown in FIG. 1, and has the output end connected to the first end of the fixed inductor 213 (fixed inductor 223) shown in FIG. 1.

Here, a longitudinal direction of the signal line 10 (a direction in which the signal line 10 extends) will be simply referred to as a longitudinal direction X. A direction from the input end to the output end of the signal line 10 along the longitudinal direction X will be referred to as a +X direction or a right side. A direction opposite to the right side will be referred to as a left side or a -X direction. A direction intersecting (for example, orthogonal to) the signal line 10 will be referred to as an intersection direction Y. One direction along the intersection direction Y will be referred to as a rear side or a +Y direction. A direction opposite to the rear side will be referred to as a front side or a -Y direction. A direction intersecting (for example, orthogonal to) both the longitudinal direction X and the intersection direction Y will be referred to as an up-down direction Z. One direction along the up-down direction Z will be referred to as an upper side or a +Z direction. A direction opposite to the upper side will be referred to as a lower side or a -Z direction. A view in the up-down direction Z will be referred to as a plan view.

In addition, the up-down direction Z need not coincide with a vertical direction. In addition, the "upper side" and the "lower side" need not coincide with an upper side and a lower side in the vertical direction. In addition, the +X direction and the -X direction may be defined as a left side and a right side instead of defining the +X direction and the -X direction as a right side and a left side.

The signal line 10 has, electrically, an inductance L1 as a concentrated constant circuit. The inductance L1 is a parasitic inductance having magnitude corresponding to a shape of the signal line 10, such as a length of the signal line 10.

In the following description, one side (+Y side) of the signal line 10 in the Y direction will be referred to as a first side of the signal line 10, and the other side (-Y side) of the signal line 10 in the Y direction will be referred to as a second side of the signal line 10. The first parallel line 21p1 is a linear strip-shaped conductor provided on the second side (-Y side) of the signal line 10. The first parallel line 21p1 is an elongated plate-shaped conductor having a constant width, a constant thickness, and a predetermined length. The first parallel line 21p1 extends parallel to the signal line 10 (in the longitudinal direction X). The first parallel line 21p1 and the signal line 10 are disposed with a spacing in the intersection direction Y. Among the ends of the first parallel line 21p1, an end located on the -X side will be referred to as a first end (one end), and an end located on the +X side will be referred to as a second end (the other end). Among the side edges of the first parallel line 21p1, a side edge located on the +Y side will be referred to as a first side edge (one side edge), and a side edge located on the -Y side will be referred to as a second side edge (the other side edge).

The upper pad 21d1 is a rectangular flat plate conductor connected to the first end (-X side) of the first parallel line 21p1. Long sides of the upper pad 21d1 extend in the intersection direction Y, and short sides of the upper pad 21d1 extend in the longitudinal direction X. Among the short sides of the upper pad 21d1, a short side located on the +Y side will be referred to as a first short side (one short side), and a short side located on the -Y side will be referred to as a second short side (the other short side). The first short side (+Y side) of the upper pad 21d1 is located at substantially the same position as the first side edge (+Y side) of the first parallel line 21p1. In addition, the second short side (-Y side) of the upper pad 21d1 is located on the front side (-Y side) with respect to the second side edge (-Y side) of the first parallel line 21p1. That is, a dimension of the upper pad 21d1 in the intersection direction Y is greater than a width (a dimension in the intersection direction Y) of the first parallel line 21p1.

The upper pad 21d2 is a rectangular flat plate conductor connected to the second end (+X side) of the first parallel line 21p1. Long sides of the upper pad 21d2 extend in the intersection direction Y, and short sides of the upper pad 21d2 extend in the longitudinal direction X. Among the short sides of the upper pad 21d2, a short side located on the +Y side will be referred to as a first short side (one short side), and a short side located on the -Y side will be referred to as a second short side (the other short side). The first short side (+Y side) of the upper pad 21d2 is located at substantially the same position as the first side edge (+Y side) of the first parallel line 21p1. In addition, the second short side (-Y side) of the upper pad 21d2 is located on the front side (-Y side) with respect to the second side edge (-Y side) of the first parallel line 21p1. That is, a dimension of the upper pad 21d2 in the intersection direction Y is greater than a width (a dimension in the intersection direction Y) of the first parallel line 21p1.

The second parallel line 22p2 is a linear strip-shaped conductor provided on the first side (+Y side) of the signal line 10. The second parallel line 22p2 is an elongated plate-shaped conductor having a constant width, a constant thickness, and a predetermined length. The second parallel line 22p2 extends parallel to the signal line 10 (in the longitudinal direction X). The second parallel line 22p2 and the signal line 10 are disposed with a spacing in the intersection direction Y. Among the ends of the second parallel line 22p2, an end located on the -X side will be referred to as a first end (one end), and an end located on the +X side will be referred to as a second end (the other end). Among the side edges of the second parallel line 22p2, a side edge located on the -Y side will be referred to as a first side edge (one side edge), and a side edge located on the +Y side will be referred to as a second side edge (the other side edge).

The second parallel line 22p2 is provided on an opposite side to the first parallel line 21p1 with respect to the signal line 10. In other words, the second parallel line 22p2 is disposed such that the signal line 10 is located between the first parallel line 21p1 and the second parallel line 22p2 in the intersection direction Y.

The first intersecting line 22c1 is a linear strip-shaped conductor connected to the first end (-X side) of the second parallel line 22p2. The first intersecting line 22c1 is an elongated plate-shaped conductor having a constant width, a constant thickness, and a predetermined length. The first intersecting line 22c1 extends away from the signal line 10 from the first end (-X side) of the second parallel line 22p2 in the intersection direction Y. That is, the first intersecting line 22c1 in the present embodiment extends toward the rear side (+Y side) from the first end (-X side) of the second parallel line 22p2. An end edge (-Y side) of the first intersecting line 22c1 on the front side is located at substantially the same position as the first side edge (-Y side) of the second parallel line 22p2. Among the ends of the first intersecting line 22c1, an end located on the +Y side will be referred to as a first end (one end), and an end located on the -Y side will be referred to as a second end (the other end).

The upper pad 22d is a rectangular flat plate conductor connected to the second end (+X side) of the second parallel line 22p2. Long sides of the upper pad 22d extend in the intersection direction Y, and short sides of the upper pad 22d extend in the longitudinal direction X. Among the short sides of the upper pad 22d, a short side located on the -Y side will be referred to as a first short side (one short side), and a short side located on the +Y side will be referred to as a second short side (the other short side). The first short side (-Y side) of the upper pad 22d is located at substantially the same position as the first side edge (-Y side) of the second parallel line 22p2. In addition, the second short side (+Y side) of the upper pad 22d is located on the rear side (+Y side) with respect to the second side edge (+Y side) of the second parallel line 22p2. That is, a dimension of the upper pad 22d in the intersection direction Y is greater than a width (dimension in the intersection direction Y) of the second parallel line 22p2.

The third parallel line 22p3 is a linear strip-shaped conductor connected to the first end (+Y side) of the first intersecting line 22c1. The third parallel line 22p3 is an elongated plate-shaped conductor having a constant width, a constant thickness, and a predetermined length. The third parallel line 22p3 extends parallel to the signal line 10 (in the longitudinal direction X) from the first end (+Y side) of the first intersecting line 22c1. That is, the third parallel line 22p3 in the present embodiment extends toward the right side (+X side) from the first end (+Y side) of the first intersecting line 22c1. Among the ends of the third parallel line 22p3, an end located on the +X side will be referred to as a first end (one end), and an end located on the -X side will be referred to as a second end (the other end).

The third parallel line 22p3 is provided at a position farther from the signal line 10 than the second parallel line 22p2 on the first side (+Y side) of the signal line 10. In other words, the third parallel line 22p3 is disposed such that the second parallel line 22p2 is located between the signal line 10 and the third parallel line 22p3 in the intersection direction Y.

As shown in FIG. 8, in the intersection direction Y, a distance d1 between a center line of the second parallel line 22p2 and a center line of the third parallel line 22p3 is greater than a distance d2 between the center line of the second parallel line 22p2 and the outer edge (an outer edge on the third parallel line 22p3 side) on the rear side of the first ground conductor 31. In addition, a right end of the third parallel line 22p3 (that is, the first end (+X side) of the third parallel line 22p3) is located on the right side (+X side) with respect to the long side of the upper pad 22d of the second line 22 on the right side (+X side).

The second intersecting line 22c2 is a linear strip-shaped conductor connected to the first end (+X side) of the third parallel line 22p3. The second intersecting line 22c2 is an elongated plate-shaped conductor having a constant width, a constant thickness, and a predetermined length. The second intersecting line 22c2 extends toward the signal line 10 in the intersection direction Y from the first end (+X side) of the third parallel line 22p3. That is, the second intersecting line 22c2 in the present embodiment extends toward the front side (-Y side) from the first end (+X side) of the third parallel line 22p3. Among the ends of the second intersecting line 22c2, an end located on the -Y side will be referred to as a first end (one end), and an end located on the +Y side will be referred to as a second end (the other end).

A first end edge (-Y side) of the second intersecting line 22c2 in the present embodiment is located at substantially the same position as the first short side (-Y side) of the upper pad 22d and the first side edge (-Y side) of the second parallel line 22p2. In addition, the upper pad 22d and the second intersecting line 22c2 are disposed with a spacing in the longitudinal direction X. In addition, a left side edge (-X side) of the second intersecting line 22c2 in the present embodiment is located at substantially the same position as a right end edge (+X side) of the signal line 10.

In addition, the first end (-Y side) of the second intersecting line 22c2 in the present embodiment is always electrically connected to the second ground conductor 32 by a conductor (not shown). In other words, one end of the second line 22 is always electrically connected to the second ground conductor 32 by a conductor (not shown).

The first intersecting line 22c1, the third parallel line 22p3, and the second intersecting line 22c2 described above constitute a loop line that is looped in a U-shape to be convex toward the rear side (+Y side).

The first ground conductor 31 is a plate-shaped conductor that is provided on the input end side (-X side) of the signal line 10. The first ground conductor 31 is electrically grounded. In addition, a rectangular notch 31a is formed on a side edge of the first ground conductor 31 on the right side (+X side). In the present embodiment, the notch 31a is formed so that the first ground conductor 31 and the signal line 10 do not overlap each other in the longitudinal direction X.

In addition, in the present embodiment, a portion of the first ground conductor 31 located on the left side (-X side) with respect to the notch 31a will be referred to as a "base portion 31b", a portion of the first ground conductor 31 located on the front side (-Y side) with respect to the notch 31a will be referred to as a "first protrusion portion 31c", and a portion of the first ground conductor 31 located on the rear side (+Y side) with respect to the notch 31a will be referred to as a "second protrusion portion 31d". Each of the first protrusion portion 31c and the second protrusion portion 31d protrudes toward the right side (+X side) from the base portion 31b. The first ground conductor 31 need not be formed with the notch 31a, the first protrusion portion 31c, and the second protrusion portion 31d. For example, the shape of the first ground conductor 31 in a plan view may be a rectangular shape.

Each of the first protrusion portion 31c and the second protrusion portion 31d has a rectangular shape in which long sides extend in the intersection direction Y and short sides extend in the longitudinal direction X. The first protrusion portion 31c overlaps the upper pad 21d1 in the up-down direction Z. The second protrusion portion 31d overlaps an end portion of the first intersecting line 22c1 on the front side (-Y side) in the up-down direction Z. As shown in FIG. 9, the first ground conductor 31 is located below the signal line 10, the first line 21 (upper pad 21d1), and the second line 22 (first intersecting line 22c1).

The second ground conductor 32 is a plate-shaped conductor that is provided on the output end side (+X side) of the signal line 10. The second ground conductor 32 is electrically grounded. Although detailed illustration is omitted, the second ground conductor 32 is located below the signal line 10 and the second line 22 (second intersecting line 22c2).

As shown in FIG. 9, a first connection pad P1 includes the upper pad 21d1 described above, an upper intermediate pad 71a, a lower intermediate pad 71b, and the first protrusion portion 31c described above. The upper pad 21d1, the upper intermediate pad 71a, the lower intermediate pad 71b, and the first protrusion portion 31c overlap each other in a plan view. In addition, the upper pad 21d1, the upper intermediate pad 71a, the lower intermediate pad 71b, and the first protrusion portion 31c are arranged in that order from the upper side (+Z side) to the lower side (-Z side) and are disposed with spacings in the up-down direction Z.

Although detailed illustration is omitted, the upper pad 21d1, the upper intermediate pad 71a, the lower intermediate pad 71b, and the first protrusion portion 31c in the present embodiment have substantially the same shape as each other. That is, the positions and the dimensions of the upper pad 21d1, the upper intermediate pad 71a, the lower intermediate pad 71b, and the first protrusion portion 31c in the longitudinal direction X and the intersection direction Y are substantially the same as each other. In FIG. 8, the dimensions of the first protrusion portion 31c are shown to be large to improve visibility of each component.

As shown in FIG. 9, the upper pad 21d1 and the upper intermediate pad 71a are electrically and mechanically connected to each other through the plurality of connection conductors 50. In addition, the upper intermediate pad 71a and the lower intermediate pad 71b are electrically and mechanically connected to each other through the plurality of connection conductors 50. In addition, the lower intermediate pad 71b and the first protrusion portion 31c are electrically and mechanically connected to each other through the plurality of connection conductors 50. As a result, the first connection pad P1 is always electrically connected to the first end (-X side) of the first parallel line 21p1 and the first ground conductor 31.

In the present specification, the "connection conductor 50" is a conductor extending in the up-down direction Z, and is a member that electrically and mechanically connects a member connected to an upper end of the connection conductor 50 and a member connected to a lower end of the connection conductor 50. The connection conductor 50 is, for example, a via that penetrates an insulating layer (not shown) in the up-down direction Z.

As shown in FIG. 9, a second connection pad P2 includes an end portion of the first intersecting line 22c1 described above on the front side (-Y side), an upper intermediate pad 72a, a lower intermediate pad 72b, and the second protrusion portion 31d described above. The end portion of the first intersecting line 22c1 on the front side (-Y side), the upper intermediate pad 72a, the lower intermediate pad 72b, and the second protrusion portion 31d overlap each other in a plan view. In addition, the end portion of the first intersecting line 22c1 on the front side (-Y side), the upper intermediate pad 72a, the lower intermediate pad 72b, and the second protrusion portion 31d are arranged in that order from the upper side (+Z side) to the lower side (-Z side) and are disposed with spacings in the up-down direction Z.

Although detailed illustration is omitted, the upper intermediate pad 72a, the lower intermediate pad 72b, and the second protrusion portion 31d in the present embodiment have substantially the same shape as each other. That is, the positions and the dimensions of the upper intermediate pad 72a, the lower intermediate pad 72b, and the second protrusion portion 31d in the longitudinal direction X and the intersection direction Y are substantially the same as each other. In FIG. 8, the dimensions of the second protrusion portion 31d are shown to be large to improve visibility of each component.

As shown in FIG. 9, the end portion of the first intersecting line 22c1 on the front side (-Y side) and the upper intermediate pad 72a are electrically and mechanically connected to each other through the plurality of connection conductors 50. In addition, the upper intermediate pad 72a and the lower intermediate pad 72b are electrically and mechanically connected to each other through the plurality of connection conductors 50. In addition, the lower intermediate pad 72b and the second protrusion portion 31d are electrically and mechanically connected to each other through the plurality of connection conductors 50. As a result, the second connection pad P2 is always electrically connected to the first end (-X side) of the second parallel line 22p2 and the first ground conductor 31.

As shown in FIG. 10, a third connection pad P3 includes the upper pad 21d2 described above, an upper intermediate pad 73a, a lower intermediate pad 73b, and a lower pad 33a. The upper pad 21d2, the upper intermediate pad 73a, the lower intermediate pad 73b, and the lower pad 33a overlap each other in a plan view. In addition, the upper pad 21d2, the upper intermediate pad 73a, the lower intermediate pad 73b, and the lower pad 33a are arranged in that order from the upper side (+Z side) to the lower side (-Z side) and are disposed with spacings in the up-down direction Z.

Here, as shown in FIG. 8, the lower pad 33a is a rectangular flat plate conductor in which long sides extend in the intersection direction Y and short sides extend in the longitudinal direction X. The lower pad 33a is provided separately from the second ground conductor 32. The presence or absence of the electrical connection between the lower pad 33a and the second ground conductor 32 is switched depending on a state of a first electronic switch 41. Accordingly, the presence or absence of the electrical grounding of the lower pad 33a is switched depending on the state of the first electronic switch 41.

Although detailed illustration is omitted, the upper pad 21d2, the upper intermediate pad 73a, the lower intermediate pad 73b, and the lower pad 33a in the present embodiment have substantially the same shape as each other. That is, the positions and the dimensions of the upper pad 21d2, the upper intermediate pad 73a, the lower intermediate pad 73b, and the lower pad 33a in the longitudinal direction X and the intersection direction Y are substantially the same as each other. In FIG. 8, the dimensions of the lower pad 33a are shown to be large to improve visibility of each component.

As shown in FIG. 10, the upper pad 21d2 and the upper intermediate pad 73a are electrically and mechanically connected to each other through a plurality of connection conductors 50. In addition, the upper intermediate pad 73a and the lower intermediate pad 73b are electrically and mechanically connected to each other through the plurality of connection conductors 50. In addition, the lower intermediate pad 73b and the lower pad 33a are electrically and mechanically connected to each other through the plurality of connection conductors 50. As a result, the third connection pad P3 is always electrically connected to the second end (+X side) of the first parallel line 21p1 and the first electronic switch 41.

As shown in FIG. 10, a fourth connection pad P4 includes the upper pad 22d described above, an upper intermediate pad 74a, a lower intermediate pad 74b, and a lower pad 33b. The upper pad 22d, the upper intermediate pad 74a, the lower intermediate pad 74b, and the lower pad 33b overlap each other in a plan view. In addition, the upper pad 22d, the upper intermediate pad 74a, the lower intermediate pad 74b, and the lower pad 33b are arranged in that order from the upper side (+Z side) to the lower side (-Z side) and are disposed with spacings in the up-down direction Z.

Here, as shown in FIG. 8, the lower pad 33b is a rectangular flat plate conductor in which long sides extend in the intersection direction Y and short sides extend in the longitudinal direction X. The lower pad 33b is provided separately from the second ground conductor 32 and the lower pad 33a. The presence or absence of the electrical connection between the lower pad 33b and the second ground conductor 32 is switched depending on a state of a second electronic switch 42. Accordingly, the presence or absence of the electrical grounding of the lower pad 33b is switched depending on the state of the second electronic switch 42.

Although detailed illustration is omitted, the upper pad 22d, the upper intermediate pad 74a, the lower intermediate pad 74b, and the lower pad 33b in the present embodiment have substantially the same shape as each other. That is, the positions and the dimensions of the upper pad 22d, the upper intermediate pad 74a, the lower intermediate pad 74b, and the lower pad 33b in the longitudinal direction X and the intersection direction Y are substantially the same as each other. In FIG. 8, the dimensions of the lower pad 33b are shown to be large to improve visibility of each component.

Here, as described above, the dimension of the upper pad 22d in the intersection direction Y is greater than the width (the dimension in the intersection direction Y) of the second parallel line 22p2 (see also FIG. 8). Therefore, the maximum value of the dimension of the fourth connection pad P4 in the intersection direction Y is greater than the width (the dimension in the intersection direction Y) of the second parallel line 22p2.

In addition, as described above, the first end edge (-Y side) of the second intersecting line 22c2 in the present embodiment is located at substantially the same position as the first short side (-Y side) of the upper pad 22d (see also FIG. 8). Accordingly, at least a part of the second intersecting line 22c2 and at least a part (in the present embodiment, the entirety) of the fourth connection pad P4 face each other in the longitudinal direction X.

As shown in FIG. 8, the first electronic switch 41 is a transistor that openably and closably connects the lower pad 33a of the third connection pad P3 and the second ground conductor 32. As shown in FIG. 8, the first electronic switch 41 in the present embodiment is, for example, a MOS type FET, in which a drain terminal is connected to the lower pad 33a of the third connection pad P3, a source terminal is connected to the second ground conductor 32, and a gate terminal is connected to the switch control unit 80.

The first electronic switch 41 switches the conduction state between the drain terminal and the source terminal between the open state and the closed state based on a gate signal input to the gate terminal from the switch control unit 80. That is, the first electronic switch 41 switches the conduction state and the cut-off state between the second end (+X side) of the first parallel line 21p1 and the second ground conductor 32 by the switch control unit 80.

As shown in FIG. 8, the second electronic switch 42 is a transistor that openably and closably connects the lower pad 33b of the fourth connection pad P4 and the second ground conductor 32. As shown in FIG. 8, the second electronic switch 42 in the present embodiment is, for example, a MOS type FET, in which a drain terminal is connected to the lower pad 33b of the fourth connection pad P4, a source terminal is connected to the second ground conductor 32, and a gate terminal is connected to the switch control unit 80.

The second electronic switch 42 switches the conduction state between the drain terminal and the source terminal between the open state and the closed state based on a gate signal input to the gate terminal from the switch control unit 80. That is, the second electronic switch 42 switches the conduction state and the cut-off state between the second end (+X side) of the second parallel line 22p2 and the second ground conductor 32 by the switch control unit 80.

The switch control unit 80 is a control circuit that controls the first electronic switch 41 and the second electronic switch 42 described above. The switch control unit 80 includes two output ports, and individually outputs the gate signals to the gate terminals of the first electronic switch 41 and the second electronic switch 42 from the output ports. That is, the switch control unit 80 controls the first electronic switch 41 and the second electronic switch 42 between the open state or the closed state by the gate signal. The switch control unit 80 is provided in the control unit (not shown) that controls, for example, the switch element 102 and the switch elements 214 and 224 shown in FIG. 1 to change the phase shift amount of the digital phase shift circuit PS1.

Next, the operations of the variable inductor ID4 configured as described above will be described.

In the variable inductor ID4 in the present embodiment, the operation mode is switched depending on the conduction states of the first electronic switch 41 and the second electronic switch 42. That is, the operation mode of the variable inductor ID4 includes a low-inductance mode in which the first electronic switch 41 and the second electronic switch 42 are set to the closed state by the switch control unit 80, and a high-inductance mode in which the first electronic switch 41 and the second electronic switch 42 are set to the open state by the switch control unit 80.

In the low-inductance mode, the switch control unit 80 sets the first electronic switch 41 and the second electronic switch 42 to the closed state.

By setting the first electronic switch 41 to the closed state, the second end (+X side) of the first parallel line 21p1 is connected to the second ground conductor 32 through the third connection pad P3 (see FIG. 8). On the other hand, the first end (-X side) of the first parallel line 21p1 is always connected to the first ground conductor 31 through the first connection pad P1 (see FIGS. 8 and 9). Therefore, the first parallel line 21p1 forms a first current path in which the current can flow between the first end (-X side) and the second end (+X side) by connecting the second end (+X side) to the second ground conductor 32 through the first electronic switch 41.

**In** addition, by setting the second electronic switch 42 to the closed state, the second end (+X side) of the second parallel line 22p2 is connected to the second ground conductor 32 through the fourth connection pad P4 (see FIG. 8). On the other hand, the first end (-X side) of the second parallel line 22p2 is always connected to the first ground conductor 31 through the second connection pad P2 (see FIGS. 8 and 9). Therefore, the second parallel line 22p2 forms a second current path in which the current can flow between the first end (-X side) and the second end (+X side) by connecting the second end (+X side) to the second ground conductor 32 through the second electronic switch 42.

In a state in which both ends of the first parallel line 21p1 and the second parallel line 22p2 are connected to each other, when a signal current flows from the input end toward the output end in the signal line 10, a return current is generated in the first parallel line 21p1 and the second parallel line 22p2 due to the propagation of the signal current. The return current flows through the first parallel line 21p1 and the second parallel line 22p2 from the second end (+X side) to the first end (-X side).

That is, in the first parallel line 21p1 forming the first current path, a first return current flows in a direction opposite to the current direction of the signal current due to the flow of the signal current in the signal line 10. In addition, in the second parallel line 22p2 forming the second current path, a second return current flows in a direction opposite to the current direction of the signal current, that is, the same direction as the first return current, due to the flow of the signal current in the signal line 10.

Here, both the first return current flowing through the first parallel line 21p1 and the second return current flowing through the second parallel line 22p2 flow in a direction opposite to the current direction of the signal current. Accordingly, the first return current and the second return current act to reduce the overall inductance of the variable inductor ID4 due to electromagnetic coupling (mutual induction) between the signal line 10 and the first parallel line 21p1 and electromagnetic coupling (mutual induction) between the signal line 10 and the second parallel line 22p2. It is assumed that an inductance of the signal line 10 is Ls_{low}, an inductance of the return path (first parallel line 21p1 and second parallel line 22p2) is Lg_{low}, and a mutual inductance between the signal line 10 and the return path is M_{low}. An overall inductance L_{low} of the variable inductor ID4 in the low-inductance mode is Ls_{low} + Lg_{low} - M_{low}.

As described above, in the high-inductance mode, the first electronic switch 41 and the second electronic switch 42 are set to the open state. Therefore, the above-described first current path is not formed in the first parallel line 21p1, and the above-described second current path is not formed in the second parallel line 22p2. Therefore, the first return current flowing through the first parallel line 21p1 becomes extremely small, and the second return current flowing through the second parallel line 22p2 becomes extremely small.

On the other hand, the end portion of the first intersecting line 22c1 on the front side (-Y side) is always connected to the first ground conductor 31 through the second connection pad P2 (see FIG. 9). In addition, as described above, the first end (-Y side) of the second intersecting line 22c2 is always connected to the second ground conductor 32. Therefore, a third current path through which the current can flow from the first end (-Y side) of the second intersecting line 22c2 to the end portion on the front side (-Y side) of the first intersecting line 22c1 is formed in advance in the first intersecting line 22c1, the third parallel line 22p3, and the second intersecting line 22c2. Therefore, in the high-inductance mode, a third return current flows from the first end (-Y side) of the second intersecting line 22c2 to the end portion on the front side (-Y side) of the first intersecting line 22c1 through the third parallel line 22p3 due to the signal current in the signal line 10.

Here, the third return current flows in a direction opposite to the current direction of the signal current in the signal line 10 in the third parallel line 22p3 parallel to the signal line 10. In addition, the second intersecting line 22c2, the third parallel line 22p3, and the first intersecting line 22c1 through which the third return current flows constitute a loop line that is looped in a U-shape to be convex toward a side opposite to the signal line 10 (+Y side). Therefore, the inductance of the return path can be increased as compared with the configuration in the related art in which the return path (a path through which the third return current flows) does not constitute the loop line. As a result, it is possible to increase the overall inductance of the variable inductor ID4. It is assumed that an inductance of the signal line 10 is Ls_{high}, an inductance of the return path (the second intersecting line 22c2, the third parallel line 22p3, and the first intersecting line 22c1) is Lg_{high}, and a mutual inductance between the signal line 10 and the return path is M_{high}. An overall inductance L_{high} of the variable inductor ID4 in the high-inductance mode is Ls_{high} + Lg_{high} - M_{high}. Here, it is clear that Lg_{low} < Lg_{high} and M_{low} > M_{high} are satisfied, so that L_{high} > L_{low} is satisfied.

The principle in which the third return current acts to increase the inductance of the return path can be described as follows. That is, a magnetic field generated in a case in which the third return current flows through the second intersecting line 22c2, a magnetic field generated in a case in which the third return current flows through the third parallel line 22p3, and a magnetic field generated in a case in which the third return current flows through the first intersecting line 22c1 are all in the same direction (+Z direction) at the center O (see FIG. 8) of the loop line. Therefore, these magnetic fields strengthen each other. Therefore, it is possible to increase the magnetic field generated by the third return current and to increase the inductance of the return path, as compared with the configuration in the related art in which the line through which the third return current flows does not constitute the loop line. In addition, by adjusting the height of the loop (that is, the position of the third parallel line 22p3 in the intersection direction Y and the lengths of the first intersecting line 22c1 and the second intersecting line 22c2), the value of the inductance of the return path can be significantly changed.

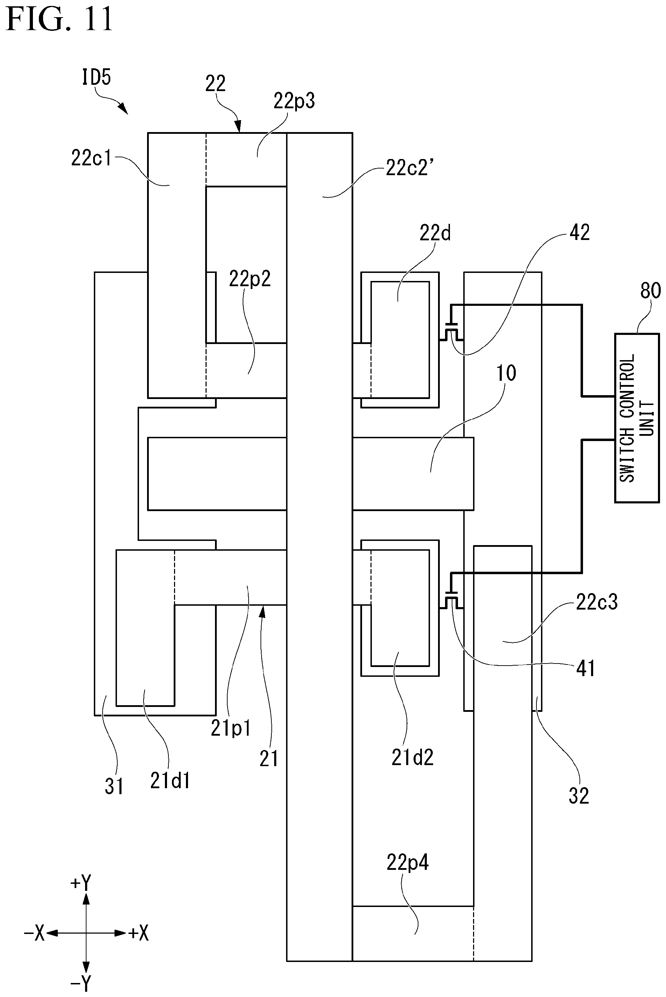

FIG. 11 is a plan view showing a fifth configuration example of the variable inductor according to the first to third embodiments of the present invention. The basic configuration of the variable inductor ID5 shown in FIG. 11 is the same as the configuration of the variable inductor ID4 shown in FIG. 8. Therefore, the same configurations are denoted by the same reference signs, the description thereof will be omitted, and only a difference will be described.

As shown in FIG. 11, the variable inductor ID5 has a different configuration of the second line 22 from the variable inductor ID4 shown in FIG. 8. Specifically, the second line 22 includes the second parallel line 22p2, the first intersecting line 22c1, the third parallel line 22p3, a second intersecting line 22c2', a fourth parallel line 22p4, a third intersecting line 22c3, and the upper pad 22d.

The second intersecting line 22c2' is provided instead of the second intersecting line 22c2 shown in FIG. 8. In the present embodiment, the right end of the third parallel line 22p3 (that is, the first end (+X side) of the third parallel line 22p3) is located on the left side (-X side) with respect to the right end of the second parallel line 22p2 (that is, the second end (+X side) of the second parallel line 22p2). In addition, the second intersecting line 22c2' in the present embodiment is different from the second intersecting line 22c2 shown in FIG. 8, and extends to intersect the second parallel line 22p2, the signal line 10, and the first parallel line 21p1 in plan view.

The second intersecting line 22c2' is located above the second parallel line 22p2, the signal line 10, and the first parallel line 21p1 such that the second intersecting line 22c2' does not come into contact with the second parallel line 22p2, the signal line 10, and the first parallel line 21p1. More specifically, the second intersecting line 22c2' is formed in another conductive layer that faces the conductive layer, in which the second parallel line 22p2, the signal line 10, and the first parallel line 21p1 are formed, with the insulating layer interposed therebetween. In addition, the second intersecting line 22c2' is located above the third parallel line 22p3, and the second end (+Y side) of the second intersecting line 22c2' and the right end (+X side) of the third parallel line 22p3 are electrically connected to each other through the conductor (not shown) (for example, a via). The second intersecting line 22c2' may be located below the second parallel line 22p2, the signal line 10, and the first parallel line 21p1. However, the configuration in which the second intersecting line 22c2' is located above the second parallel line 22p2, the signal line 10, and the first parallel line 21p1 is suitable from the viewpoint that the wiring can be easily thickened, and accordingly, the resistance value of the wiring can be easily lowered.

The fourth parallel line 22p4 and the third intersecting line 22c3 are located at the same positions as the second parallel line 22p2, the first intersecting line 22c1, and the third parallel line 22p3 in the up-down direction Z. That is, the fourth parallel line 22p4 and the third intersecting line 22c3 are formed in the same conductive layer as the second parallel line 22p2, the first intersecting line 22c1, and the third parallel line 22p3.

The fourth parallel line 22p4 is a linear strip-shaped conductor connected to a first end (-Y side) of the second intersecting line 22c2'. The fourth parallel line 22p4 is an elongated plate-shaped conductor having a constant width, a constant thickness, and a predetermined length. The fourth parallel line 22p4 extends parallel to the signal line 10 (in the longitudinal direction X) from the first end (-Y side) of the second intersecting line 22c2'. That is, the fourth parallel line 22p4 in the present embodiment extends toward the right side (+X side) from the first end (-Y side) of the second intersecting line 22c2'. Among the ends of the fourth parallel line 22p4, an end located on the +X side will be referred to as a first end (one end), and an end located on the -X side will be referred to as a second end (the other end). The first end (-Y side) of the second intersecting line 22c2' and the left end of the fourth parallel line 22p4 (that is, the second end (-X side) of the fourth parallel line 22p4) are electrically connected to each other through the conductor (not shown) (for example, a via).

The fourth parallel line 22p4 is provided at a position farther from the signal line 10 than the first parallel line 21p1 on the second side (-Y side) of the signal line 10. In other words, the fourth parallel line 22p4 is disposed such that the first parallel line 21p1 is located between the signal line 10 and the fourth parallel line 22p4 in the intersection direction Y. In addition, the right end of the fourth parallel line 22p4 (that is, the first end (+X side) of the fourth parallel line 22p4) is located to the right side (+X side) with respect to the long side of the upper pad 21d2 of the first line 21 on the right side (+X side).

The third intersecting line 22c3 is a linear strip-shaped conductor connected to the first end (+X side) of the fourth parallel line 22p4. The third intersecting line 22c3 is an elongated plate-shaped conductor having a constant width, a constant thickness, and a predetermined length. The third intersecting line 22c3 extends toward the signal line 10 in the intersection direction Y from the first end (+X side) of the fourth parallel line 22p4. That is, the third intersecting line 22c3 in the present embodiment extends toward the rear side (+Y side) from the first end (+X side) of the fourth parallel line 22p4. Among the ends of the third intersecting line 22c3, an end located on the +Y side will be referred to as a first end (one end), and an end located on the -Y side will be referred to as a second end (the other end).

In addition, the upper pad 21d2 and the third intersecting line 22c3 are disposed with a spacing in the longitudinal direction X. In addition, the first end (+Y side) of the third intersecting line 22c3 in the present embodiment is always electrically connected to the second ground conductor 32 through the conductor (not shown). In other words, one end of the second line 22 is always electrically connected to the second ground conductor 32 by a conductor (not shown).

In the variable inductor ID5 in the present embodiment, similarly to the variable inductor ID4 in the fourth configuration example, the first intersecting line 22c1, the third parallel line 22p3, and the second intersecting line 22c2' constitute a loop line that is looped in a U-shape to be convex toward the rear side (+Y side). In addition, in the variable inductor ID5 in the present embodiment, the second intersecting line 22c2', the fourth parallel line 22p4, and the third intersecting line 22c3 constitute a loop line that is looped in a U-shape to be convex toward the front side (-Y side). That is, the return path (the line through which the third return current flows) in the high-inductance mode includes two loop lines. Therefore, it is possible to further increase the magnetic field generated by the third return current, and to further increase the inductance of the return path (the overall inductance of the variable inductor ID5).

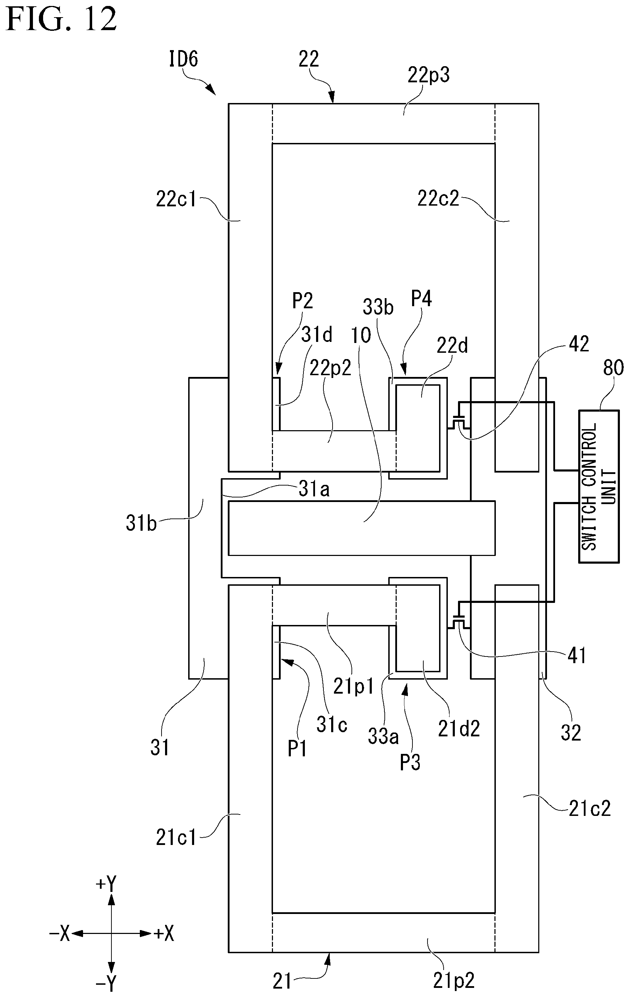

FIG. 12 is a plan view showing a sixth configuration example of the variable inductor according to the first to third embodiments of the present invention. A basic configuration of the variable inductor ID5 shown in FIG. 12 is the same as the configuration of the variable inductor ID4 shown in FIG. 8. Therefore, the same configurations are denoted by the same reference signs, the description thereof will be omitted, and only a difference will be described.

The variable inductor ID6 shown in FIG. 12 has a different configuration of the first line 21 from the variable inductor ID4 described using FIGS. 8 to 10. Specifically, the first line 21 of the variable inductor ID6 shown in FIG. 12 includes a fourth intersecting line 21c1, a fifth parallel line 21p2, and a fifth intersecting line 21c2, in addition to the first parallel line 21p1 and the upper pad 21d2. The upper pad 21d1 is omitted.

The fourth intersecting line 21c1 is a linear strip-shaped conductor connected to the first end (-X side) of the first parallel line 21p1. The fourth intersecting line 21c1 is an elongated plate-shaped conductor having a constant width, a constant thickness, and a predetermined length. The fourth intersecting line 21c1 extends away from the signal line 10 in the intersection direction Y from the first end (-X side) of the first parallel line 21p1. That is, the fourth intersecting line 21c1 in the present embodiment extends toward the front side (-Y side) from the first end (-X side) of the first parallel line 21p1. The end edge (+Y side) on the rear side of the fourth intersecting line 21c1 is located at substantially the same position as the first side edge (+Y side) of the first parallel line 21p1. Among the ends of the fourth intersecting line 21c1, an end located on the -Y side will be referred to as a first end (one end), and an end located on the +Y side will be referred to as a second end (the other end).

The fifth parallel line 21p2 is a linear strip-shaped conductor connected to the first end (-Y side) of the fourth intersecting line 21c1. The fifth parallel line 21p2 is an elongated plate-shaped conductor having a constant width, a constant thickness, and a predetermined length. The fifth parallel line 21p2 extends parallel to the signal line 10 (in the longitudinal direction X) from the first end portion (-Y side) of the fourth intersecting line 21c1. That is, the fifth parallel line 21p2 in the present embodiment extends toward the right side (+X side) from the first end portion (-Y side) of the fourth intersecting line 21c1. Among the ends of the fifth parallel line 21p2, an end located on the +X side will be referred to as a first end (one end), and an end located on the -X side will be referred to as a second end (the other end).

The fifth parallel line 21p2 is provided at a position farther from the signal line 10 than the first parallel line 21p1 on the second side (-Y side) of the signal line 10. In other words, the fifth parallel line 21p2 is disposed such that the first parallel line 21p1 is located between the signal line 10 and the fifth parallel line 21p2 in the intersection direction Y.

As shown in FIG. 12, in the intersection direction Y, a distance between the center line of the first parallel line 21p1 and the center line of the fifth parallel line 21p2 is the same as (or similar to) the distance d1 (see FIG. 8) between the center line of the second parallel line 22p2 and the center line of the third parallel line 22p3. The right end (+X side) of the fifth parallel line 21p2 is located on the right side (+X side) with respect to the long side of the upper pad 21d2 on the right side (+X side).

The fifth intersecting line 21c2 is a linear strip-shaped conductor connected to the first end (+X side) of the fifth parallel line 21p2. The fifth intersecting line 21c2 is an elongated plate-shaped conductor having a constant width, a constant thickness, and a predetermined length. The fifth intersecting line 21c2 extends toward the signal line 10 in the intersection direction Y from the first end (+X side) of the fifth parallel line 21p2. That is, the fifth intersecting line 21c2 in the present embodiment extends toward the rear side (+Y side) from the first end (+X side) of the fifth parallel line 21p2. Among the ends of the fifth intersecting line 21c2, an end located on the -Y side will be referred to as a first end (one end), and an end located on the +Y side will be referred to as a second end (the other end).

The second end edge (+Y side) of the fifth intersecting line 21c2 in the present embodiment is located at substantially the same position as the first short side (+Y side) of the upper pad 21d2 and the first side edge (+Y side) of the first parallel line 21p1 in the intersection direction Y. In addition, the upper pad 21d2 and the fifth intersecting line 21c2 are disposed with a spacing in the longitudinal direction X. In addition, a left side edge (-X side) of the fifth intersecting line in the present embodiment is located at substantially the same position as the right end edge (+X side) of the signal line 10 in the longitudinal direction X.

In addition, the second end (+Y side) of the fifth intersecting line 21c2 in the present embodiment is always electrically connected to the second ground conductor 32 through the conductor (not shown). In other words, one end of the first line 21 is always electrically connected to the second ground conductor 32 through the conductor (not shown).

The fourth intersecting line 21c1, the fifth parallel line 21p2, and the fifth intersecting line 21c2 described above constitute a loop line that is looped in a U-shape to be convex toward the front side (-Y side).

### REFERENCE SIGNS LIST

1 Signal line
2, 2a, 2b Inner line
3, 3a, 3b Outer line
4a, 4b Ground conductor
7a, 7b Electronic switch
10 Signal line
21 First line
21c1 Fourth intersecting line
21c2 Fifth intersecting line
21p1 First parallel line
21p2 Fifth parallel line
22 Second line
22c1 First intersecting line
22c2, 22c2' Second intersecting line
22c3 Third intersecting line
22p2 Second parallel line
22p3 Third parallel line
22p4 Fourth parallel line
31 First ground conductor
32 Second ground conductor
41 First electronic switch
42 Second electronic switch
100, 100A First circuit
101 Capacitor
102 Switch element
110 Capacitor circuit
111 Capacitor
112 Switch element
120 Capacitor circuit
121 Capacitor
122 Switch element
200, 200A, 200B Second circuit
201 Fixed inductor
202 Variable inductor
203 Fixed inductor
204 Switch element
210 Inductor circuit
211 Fixed inductor
212 Variable inductor
213 Fixed inductor
214 Switch element
220 Inductor circuit
221 Fixed inductor
222 Variable inductor
223 Fixed inductor
224 Switch element
230 Fixed inductor circuit
231, 232 Fixed inductor
240 Variable inductor circuit
241 Variable inductor
242 Fixed inductor
243 Switch element
ID1 to ID6 Variable inductor
L0 Common return line
Q1, Q2 Connection point
PS1 to PS3 Digital phase shift circuit
P100 First port
P200 Second port

## Claims

1. A digital phase shift circuit comprising:
a first circuit connected between a first port and a second port; and
a second circuit connected to the first circuit and a common return line and including a variable inductor configured to adjust a phase shift amount for each frequency band.

2. The digital phase shift circuit according to Claim 1,
wherein the variable inductor includes
a signal line,
an inner line including a first inner line provided on a first side of the signal line and a second inner line provided on a second side of the signal line,
an outer line provided at a position farther from the signal line than the inner line on at least one of the first side or the second side of the signal line,
a first ground conductor connected to a first end portion of the first inner line, a first end portion of the second inner line, and a first end portion of the outer line,
a second ground conductor connected to a second end portion of the outer line,
a first electronic switch provided between a second end portion of the first inner line and the second ground conductor, and
a second electronic switch provided between a second end portion of the second inner line and the second ground conductor.

3. The digital phase shift circuit according to Claim **1,**
wherein the variable inductor includes
a signal line,
a first line including a first parallel line extending parallel to the signal line,
a second line including a second parallel line extending parallel to the signal line, a first intersecting line extending away from the signal line in an intersection direction intersecting a longitudinal direction of the signal line from a first end portion of the second parallel line, a third parallel line extending parallel to the signal line from a first end portion of the first intersecting line, and a second intersecting line extending toward the signal line in the intersection direction from a first end portion of the third parallel line,
a first ground conductor electrically connected to a first end portion of the first parallel line and the first end portion of the second parallel line,
a second ground conductor connected to a first end portion of the second line,
a first electronic switch provided between a second end portion of the first parallel line and the second ground conductor, and
a second electronic switch provided between a second end portion of the second parallel line and the second ground conductor, and
the signal line is located between the first parallel line and the second parallel line.

4. The digital phase shift circuit according to Claim 3,
wherein the second intersecting line extends to intersect the second parallel line, the signal line, and the first parallel line in a plan view, and
the second line further includes a fourth parallel line extending parallel to the signal line from a first end portion of the second intersecting line, and a third intersecting line extending toward the signal line in the intersection direction from a first end portion of the fourth parallel line.

5. The digital phase shift circuit according to Claim 3,
wherein the first line further includes a fourth intersecting line extending away from the signal line in the intersection direction from the first end portion of the first parallel line, a fifth parallel line extending parallel to the signal line from a first end portion of the fourth intersecting line, and a fifth intersecting line extending toward the signal line in the intersection direction from a first end portion of the fifth parallel line.

6. The digital phase shift circuit according to any one of Claims 1 to 5,
wherein the first circuit includes a circuit in which a capacitor and a first switch element are connected in parallel,
the second circuit includes a pair of inductor circuits connected between a first end of the first circuit and the common return line and between a second end of the first circuit and the common return line, and
each of the inductor circuits is a circuit in which a first fixed inductor, the variable inductor, and a circuit including a second fixed inductor and a second switch element that are connected in parallel are connected in series.

7. The digital phase shift circuit according to any one of Claims 1 to 5,
wherein the first circuit includes a circuit in which a capacitor and a first switch element are connected in parallel,
the second circuit includes a fixed inductor circuit connected in parallel to the first circuit and a variable inductor circuit connected between the fixed inductor circuit and the common return line,
the fixed inductor circuit is a circuit including two first fixed inductors connected in series, and
the variable inductor circuit is a circuit in which the variable inductor and a circuit including a second fixed inductor and a second switch element that are connected in parallel are connected in series, and is connected to a connection point between the two first fixed inductors.

8. The digital phase shift circuit according to any one of Claims 1 to 5,
wherein the first circuit is a circuit including two capacitor circuits connected in series,
the second circuit is connected between the first circuit and the common return line,
the second circuit is a circuit in which a first fixed inductor, the variable inductor, and a circuit including a second fixed inductor and a second switch element that are connected in parallel are connected in series, and is connected to a connection point between the two capacitor circuits, and
each of the capacitor circuits is a circuit in which a capacitor and a first switch element are connected in parallel.
